# EUROPÄISCHE PATENTANMELDUNG

(11) **EP 3 053 905 A1**
(43) Veröffentlichungstag der Anmeldung: **10.08.2016**
(21) Anmeldenummer: 15153751.1
(22) Anmeldetag: 04.02.2015
(51) Int. Cl.: C07C 15/20, C08G 65/332, C08G 65/333, G03F 7/004

(54) **Durch sichtbares Licht induzierte Zykloaddition zur Polymerisation bzw. Vernetzung mittels Azirin-Verbindungen**

(71) Anmelder: Evonik Degussa GmbH, 45128 Essen (DE); Karlsruher Institut Für Technologie (KIT), 73131 Karlsruhe (DE)
(72) Erfinder: SCHMIDT, Friedrich Georg, 45721 Haltern am See (DE); BARNER-KOWOLLIK, Christopher, 76297 Stutensee (DE); MÜLLER, Jan, 64653 Lorsch (DE); BLINCO, James, 4121 Brisbane, QLD, (AU)
(74) Vertreter: Wolf, Oliver

(57) **Zusammenfassung**

Die vorliegende Erfindung betrifft photovernetzende Systeme, die mittels sichtbaren Lichts aktivierbar sind. Dabei betrifft die vorliegende Erfindung insbesondere die photoinduzierte Verknüpfungen von Doppelbindungen enthaltenden Strukturen mittels perizyllischen Reaktionen durch Zusatz von speziellen Azirin-Verbindungen. Eine Vernetzung kann dabei bereits durch sichtbares Licht, insbesondere mit einer Wellenlänge λ größer 380 nm und nicht nur durch Sonnenlicht-Einstrahlung mit einem relevanten UV-Anteil erhalten werden. Darüber hinaus betrifft die vorliegende Erfindung in einer zweiten Ausführungsform die lineare Kupplung von Polymerketten bzw. die Funktionalisierung von Polymeren.

## Beschreibung

### Gebiet der Erfindung

Die vorliegende Erfindung betrifft photovernetzende Systeme, die mittels sichtbaren Lichts aktivierbar sind. Dabei betrifft die vorliegende Erfindung insbesondere die photoinduzierte Verknüpfungen von Doppelbindungen enthaltenden Strukturen mittels perizyllischen Reaktionen durch Zusatz von speziellen Azirin-Verbindungen. Eine Vernetzung kann dabei bereits durch sichtbares Licht, insbesondere mit einer Wellenlänge λ größer 380 nm und nicht nur durch Sonnenlicht-Einstrahlung mit einem relevanten UV-Anteil erhalten werden. Darüber hinaus betrifft die vorliegende Erfindung in einer zweiten Ausführungsform die lineare Kupplung von Polymerketten bzw. die Funktionalisierung von Polymeren.

### Stand der Technik

Vinylgruppen tragende Polymere, insbesondere Polyolefine wie 1,2-Polybutadiene können mittels einer Vielzahl von Mechanismen vernetzt werden. Neben der hinlänglich bekannten Vulkanisation mit Schwefel ist vor allem die Vernetzung mit Photoinitiatoren, wie zum Beispiel Acylphosphinen oder Thiocyanatoketonen bedeutend. Gleichsam ist die direkte Vernetzung mittels energiereicher UV-Strahlung oder mit Radikalinitiatoren wie Peroxiden oder Azo-bis-isobutyronitril (AIBN). Jedoch besteht zusätzlich der Bedarf vernetzte Systeme zur Verfügung zu stellen, die einfach durch Sonneneinstrahlung vernetzbar sind.

Methoden zur photoinduzierten Vernetzung von Polymeren sind für ein breites Feld von Anwendungen von großem Interesse. Beispielsweise in Klebanwendungen sind diverse Möglichkeiten für die Automobilindustrie oder die Halbleiterindustrie beschrieben. Aber auch bei der Konstruktion von Maschinen, feinmechanischen Geräten oder in der Bauindustrie sind solche Klebstoffe interessant. 0Neben Klebanwendungen sind photoinduziert vernetzbare Polymere auch in Dichtstoffen, Beschichtungsmassen wie Lacken oder Farben oder bei der Herstellung von Formkörpern von Interesse.

In WO 2011/101176 ist die reversible Vernetzung von Poly(meth)acrylaten mittels einer Hetero-Diels-Alder-Reaktion beschrieben. Diese Reaktion lässt sich jedoch nur thermisch aktivieren und desaktivieren. Weiterhin ist der Nachteil eines solchen Systems, insbesondere für Lackanwendungen, dass eine thermisch wieder lösbare Vernetzung die Langlebigkeit und die Einsatzmöglichkeit eines solchen Systems stark einschränkt.

Die in WO 98/033855 dargelegten, durch UV-Bestrahlung härtbaren Beschichtungsmittel müssen mit sehr hohen Bestrahlungsenergien unter Ausschluss von Sauerstoff gehärtet werden. Ohne diese hohen Lichtenergien oder in Anwesenheit von Sauerstoff werden vielfach Beschichtungen erhalten, die eine geringe Resistenz gegenüber Lösungsmitteln zeigen. Dementsprechend ist die Verarbeitbarkeit dieser Beschichtungsmittel relativ aufwendig.

In US 7,829,606 sind mittels Strahlung härtbare Reaktivschmelzklebstoffe offenbart. Diese bestehen aus Polyacrylaten und langkettigen Acrylatmonomeren. Dabei erfolgt die Aushärtung anwendungsspezifisch nur mit einem relativ geringen Vernetzungsgrad. Diese Technologie lässt sich damit nicht auf andere Anwendungen, wie zum Beispiel UV-härtbare Lacke, übertragen.

Unter dem Oberbegriff "Click Chemie" werden seit einigen Jahren vor allem in der akademischen Welt Methoden zum Aufbau von Blockcopolymeren erforscht. Dabei werden zwei unterschiedliche Homopolymere mit verknüpfbaren Endgruppen miteinander kombiniert und z.B. mittels einer Diels-Alder-Reaktion, Diels-Alder-analogen Reaktion bzw. einer anderen Cycloaddition miteinander verbunden. Ziel dieser Reaktion ist es, thermisch stabile, lineare und ggf. hochmolekulare Polymerketten aufzubauen.

In Gruendling et al. (Macromol. Rapid Commun. 2011, 32, S.807-12) beispielsweise offenbaren Polymethylmethacrylate mit einer Maleinimidendgruppe, die mit Photoenolverbindungen zur Funktionalisierung - z.B. mit OH-Gruppen - gekoppelt werden.
Glassner et al. (Macromolecules, 2011, 44, S.4681-89) beschreibt die Synthese von Triblockcopolymeren mittels des gleichen Mechanismus wie Gruendling et al. Dabei werden PMMA- oder Polystyrol Polymere, die an einem Kettenenden Benzophenongruppen und an dem anderen Kettenende Cyclopentadien-Gruppen aufweisen, jeweils mit Maleinimidendgruppenmonofunktionellen PEG oder Acrylatpolymeren zu Triblockcopolymeren gekoppelt. Dabei erfolgt die Kopplung an einem Kettenende photoinduziert, während die Kopplung am anderen Kettenende, die Cyclopentadiengruppe aufweisend, thermisch induziert erfolgt.
Bei beiden Methoden müssen die jeweils endgruppenfunktionellen Polymere umständlich mittels anionischer oder im Falle von Poly(meth)acrylaten alternativ mittels einer kontrollierten radikalischen Polymerisation hergestellt werden. Weiterhin sind mittels dieser Methoden nur mono- bzw. bestenfalls bifunktionelle Polymerketten verfügbar. Damit sind jedoch Vernetzungsreaktionen ausgeschlossen.

In R. K. V. Lim, Q. Lin, Chem. Commun. 2010, 46, 7993-7995 ist eine Konjugationsmethode für die Kupplung eines Peptids mit einem Polymer beschrieben. Bei dem dort verwendeten Azirin handelt es sich um ein Diarylazirin, das an jedem Kohlenstoffatom einen phenylischen Substituenten trägt. Die Wellenlänge, bei der die Reaktion durchgeführt wurde, beträgt ca. 300 nm und liegt damit im Bereich der UVB-Strahlung. Mit elektromagnetischer Strahlung im Bereich des sichtbaren Lichts erfolgt keine Reaktion.

In I. Naito, H. Morihara, Journal of Imaging Science and Technology 1996, 40 (1), 50 ist die Vernetzung von Polymeren beschrieben, bei der ein mit zwei Azirineinheiten ausgestattetes Vernetzer-molekül verwendet wurde. Bei den für die Vernetzung verwendeten Polymeren handelt es sich um Poly(1,2-butadiene) sowie Poly(4-hydroxystyrol). Diese Vernetzung wurde ebenfalls mittels UV-Einstrahlung induziert.

In J. O. Mueller et al., Polym. Chem. 2014, 5, 1447-1456 bzw. in US 2014/0323648 sind Systeme zur Vernetzung von teilweise ungesättigten Polyolefinen mittels einer perizyklischen Reaktion beschrieben. Diese Vernetzung kann Sonnenlicht-induziert erfolgen, wobei jedoch der UV-Anteil des Sonnenlichts benötigt wird.

In DE 10 2009 051 575 bzw. in DE 10 2007 034 580 sind Biomaterialien zur Bildung von Hydrogelen oder zur Kultivierung von Zellen offenbart. Diese Biomaterialien können als eine von vielen vernetzbaren Gruppen Azirin-Gruppen aufweisen und sind in Anwesenheit spezieller Zellen, durch diese vernetzbar. Zur Herstellung von Lacken, Kleb- oder Dichtstoffen oder auch Formteilen sind solche biologisch vernetzbaren Systeme jedoch vollkommen ungeeignet.

In I. Naito, H. Morihara sind schließlich vernetzende Systeme auf Basis von Polybutadien oder anderen Polymeren mit Vernetzern, die Azirin-funktionalisiert sind. Da die Vernetzer relativ unreaktiv sind, muss die Aktivierung mit UV-Strahlung erfolgen. Dabei werden in diesem Fall Pyrrol-Bindungen erhalten. Auch beschrieben ist die gleichfalls mit UV-aktivierte Vernetzung von Poly-Hydroxy-styrol unter Bildung von Ketoximgruppen.

### Aufgabe

In Hinblick auf den Stand der Technik bestand damit die Aufgabe, eine photovernetzende bzw. mit sichtbarem Licht aktivierbare Zusammensetzung, enthaltend Polymere, die schnell und einfach mit Tageslicht zur Reaktion gebracht werden kann, zu Verfügung zu stellen.
Insbesondere bestand die Aufgabe, eine Zusammensetzung, bestehend aus einem neuartigen, für die Lichtaktivierung geeigneten Vernetzer und einem dazu passend funktionalisierten Polymersystem zur Verfügung zu stellen.

Gleichzeitig bestand die Aufgabe, neben der Vernetzung auch eine Methode zur Molekulargewichtserhöhung oder zur Funktionalisierung von Polymeren zur Verfügung zu stellen. Darüber hinaus bestand die Aufgabe, diese Zusammensetzung wahlweise mit einem zweiten Aushärt- bzw. Aktivierungsmechanismus kombinieren zu können.

Weiterhin bestand die Aufgabe, einen erwähnten Vernetzer an sich und eine möglichst einfache Syntheseroute zu dessen Herstellung zur Verfügung zu stellen.

Weitere nicht explizit aufgeführte Aufgaben können sich folgend aus der Beschreibung, den Beispielen oder den Ansprüchen ergeben.

### Lösung

Gelöst werden die Aufgaben mit einer neuartigen, photoinduziert vernetzbaren Formulierung, die eine Komponente A und eine Komponente B, für die es zwei Alternativen B1 und B2 gibt, enthält. Dabei handelt es sich bei der Komponente A um mindestens einen polycyclischen Aromaten, der mindestens eine Azirin-Gruppe aufweist.
Bei Komponente B handelt es sich einerseits um eine Komponente B1, welche mindestens ein Polymer ist. Dieses Polymer hat mindestens eine freie C-C-Doppelbindung. In einer alternativen Ausführungsform handelt es sich bei Komponente B um die Komponente B2, die eine niedermolekulare Verbindung ist und mindestens zwei C-C-Doppelbindungen aufweist. Darüber hinaus kann die Komponente A mit sichtbarem Licht bei Raumtemperatur mit der Komponente B1 oder B2 zur Reaktion gebracht werden. Insgesamt gibt es mehrere Varianten, in denen die vorliegende Erfindung genutzt werden kann.

Überraschend konnte mit dieser Erfindung gezeigt werden, dass durch Bestrahlung mit sichtbarem Licht in speziellen photoaktiven Systemen gezielt hochreaktive Zwischenstufen ohne Zugabe eines Katalysators oder den zwingenden Ausschluss von Luftsauerstoff oder Wasser erzeugt werden können, die z.B. Doppelbindungen enthaltende Polymere vernetzen. Durch die Synthese und Verwendung von mono- bzw. difunktionellen Verbindungen der Komponente A, die Azirin-Funktionalitäten enthalten, können diese unter Bestrahlung Reaktionen mit Doppelbindungen, insbesondere mit durch Konjugation aktivierte Doppelbindungen eingehen.

Unter sichtbarem Licht werden dabei erfindungsgemäß Wellenlängen zwischen 380 und 780 nm, insbesondere zwischen 380 und 580 nm und besonders bevorzugt zwischen 380 und 480 nm verstanden. Neben der Initiierung durch den sichtbaren Lichtanteil bei direkter Sonneneinstrahlung, kann die Reaktion, z.B. in Form einer Vernetzung, insbesondere auch mittels LED oder Fluoreszenzröhren erzeugt werden. Dies hat technische Vorteile, insbesondere gegenüber der Reaktionsauslösung mit schädlicher UV-Strahlung und verläuft sehr schnell bei ausreichender Strahlungsintensität.

Weitere Vorteile der vorliegenden Erfindung sind extrem schnelle Reaktionszeiten, von z.B. maximal 2 min), wenig anspruchsvolle Reaktionsbedingungen und zumeist ein vollständiger Umsatz. Wenig anspruchsvolle Reaktionsbedingungen bedeutet in diesem Zusammenhang, dass die Reaktion bei Raumtemperatur und sowohl in also auch ohne Luftatmosphäre durchgeführt werden kann.

Bei der polycyclischen aromatischen Komponente A handelt es sich bevorzugt um einen mit mindestens einer Azirin-Gruppe funktionalisiertes Pyren, Anthracen, Phenalen, Phenanthren, Tetracen, Chrysen, Perylen, Pentacen, Pentaphen oder Coronen. Besonders einfach umsetzbar und verfügbar sind dabei Pyren und Anthracen. Verbindung (1) stellt dabei ein Beispiel für ein bifunktionelles Pyren, Verbindung (2) für ein trifunktionelles Pyren und Verbindung (3) für ein bifunktionelles Anthracen dar:

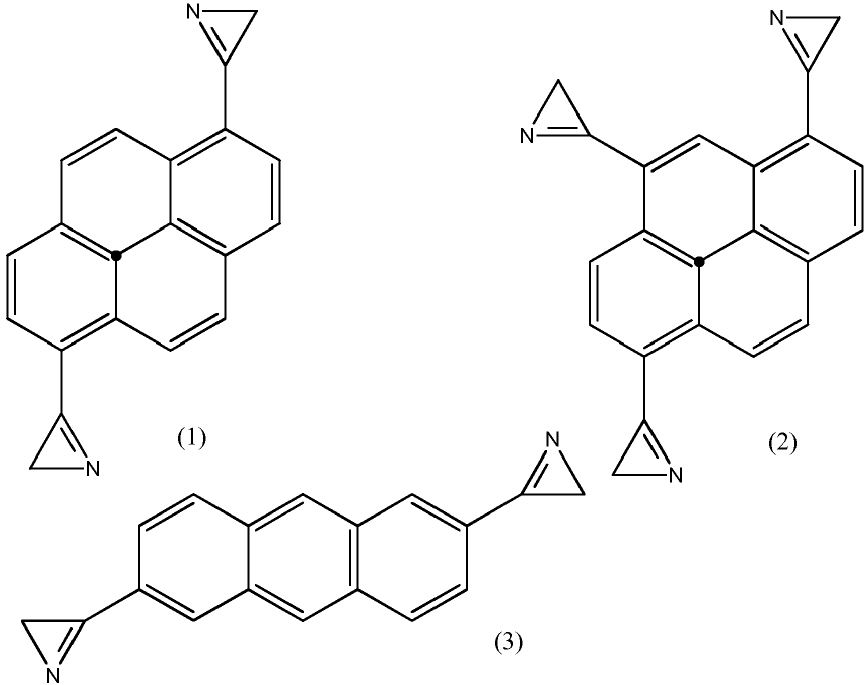

Es ist auch möglich, dass es sich bei Komponente A um eine Verbindung handelt, die mindestens zwei, jeweils mit mindestens einer Azirin-Gruppe funktionalisierte, polycyclische Aromaten aufweist, wobei die beiden polycyclischen Aromaten über einen Spacer miteinander verbunden sind. Bei diesen Spacern kann es sich beispielsweise um eine di-Säure, deren Säuregruppen beispielsweise mit Hydroxygruppen an dem Aromaten verestert werden, handeln. Ein Beispiel für eine solche Verbindung mit zwei jeweils eine Azirin-Funktionalität aufweisenden, Pyrensystemen ist Verbindung (4):

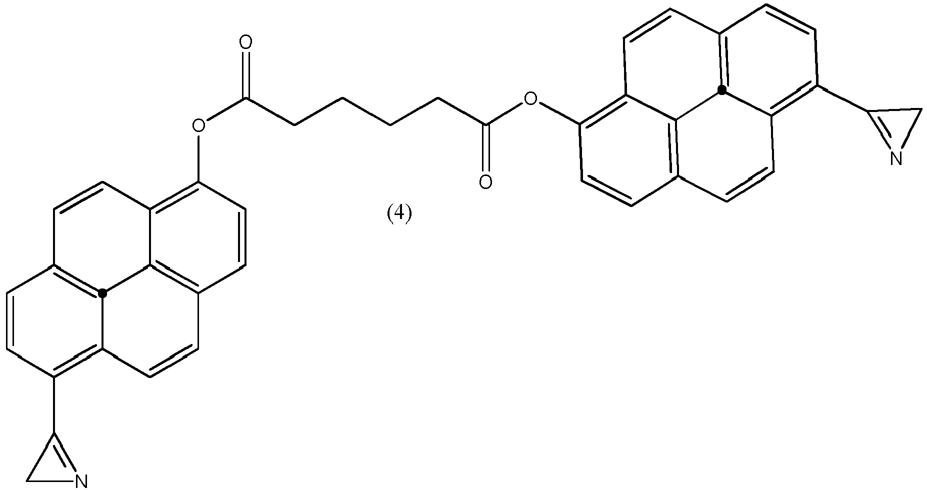

Ein zweiter sehr geeigneter Spacer wird beispielsweise aus hydroxy-telechelen Polyethern gewonnen, die mit jeweils eine Säuregruppe, bzw. ein Säurehalogenid tragenden polycyclischen Aromaten verestert werden. Ein Beispiel mit jeweils eine Azirin-Gruppe tragenden Anthracensystemen ist Verbindung (5). Hier kann n, d.h. das Molekulargewicht des Polyethers, relativ frei gewählt werden. Bevorzugt wäre eine Zahl zwischen 2 und 10, insbesondere 4, 5 oder 6:

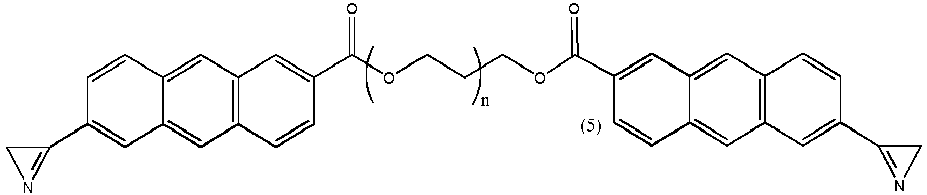

Weiterhin sind auch Varianten denkbar, bei denen das andere Kohlenstoffatom des Azirins mit dem Spacer substituiert ist. Siehe als Beispiel für eine solche Variante die Verbindung (5a). Bei R kann es sich in diesem Fall um einen zweibindigen aromatischen oder aliphatischen Rest handeln. Auch ist es möglich, dass es sich bei R um eine zweibindige oligomere oder polymere Sequenz, z.B. einen Polyether oder einen Polyester handelt. Auch muss die beispielhaft aufgeführte Sequenz zwischen den beiden Resten R nicht zwingend ein Heteroatom, wie hier zwei Sauerstoffatome, aufweisen, sondern ist gleichsam frei wählbar.

Zusammengefasst kann es sich bei einer solchen gespacerten, di- oder multifunktionellen Komponente A um eine Verbindung handelt, die mindestens zwei mit Azirin-Gruppen funktionalisierte polycyclische Aromaten aufweist, wobei entweder Kohlenstoffatome der Azirin-Gruppen oder Kohlenstoffatome in den polycyclischen Aromaten über einen Spacer miteinander verbunden sind.

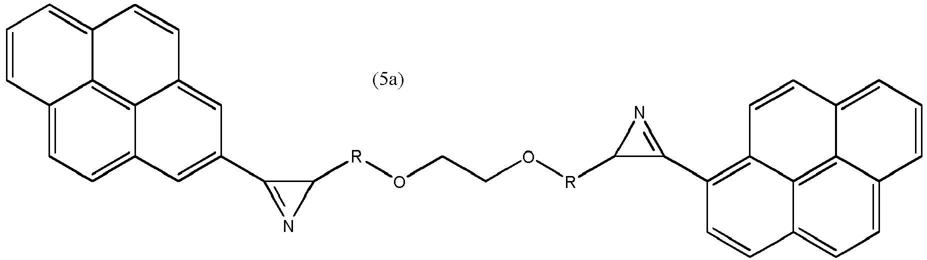

Neben Polyethern sind insbesondere auch Polyester sehr gut als Spacer verwendbar. Dabei können sowohl Polyether als auch Polyester aliphatische sein, oder überwiegend aromatische.

Neben den für die Synthese von Komponenten A gemäß den Beispielen (4) oder (5) benötigten funktionellen Gruppen, kann Komponente A zusätzlich zu den Azirin-Gruppen weitere reaktive Gruppe aufweisen. Diese können für eine weitere Funktionalisierung, eine Koordinierung oder einen weiteren Polymerisations- oder Vernetzungsmechanismus vorliegen. Auch ist es möglich mittels Spacern mehr als zwei funktionalisierte polycyclische Aromaten miteinander zu verknüpfen.

Der Reaktionsmechanismus zwischen den Komponenten A und B erfolgt unter Lichteinstrahlung vermutlich nach folgendem Mechanismus. Dabei steht Ar für den polycyclischen Aromaten und R im Falle von Komponente B1 für das Polymer und im Falle von B2 für einen Rest, der mindestens eine weitere Doppelbindung aufweist:

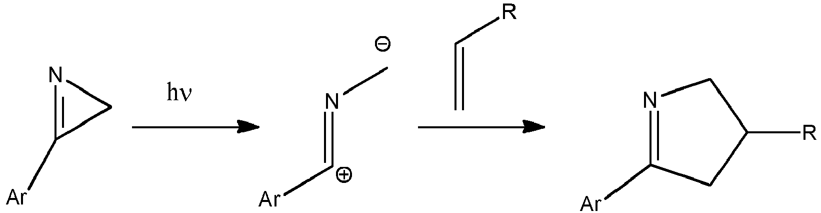

Die zwitterionische Zwischenstufen werden dabei als Nitril-Ylide bezeichnet.

Die Synthese der Azirin-funktionalisierten polycyclischen Aromaten kann z.B. über folgende Route erfolgen:

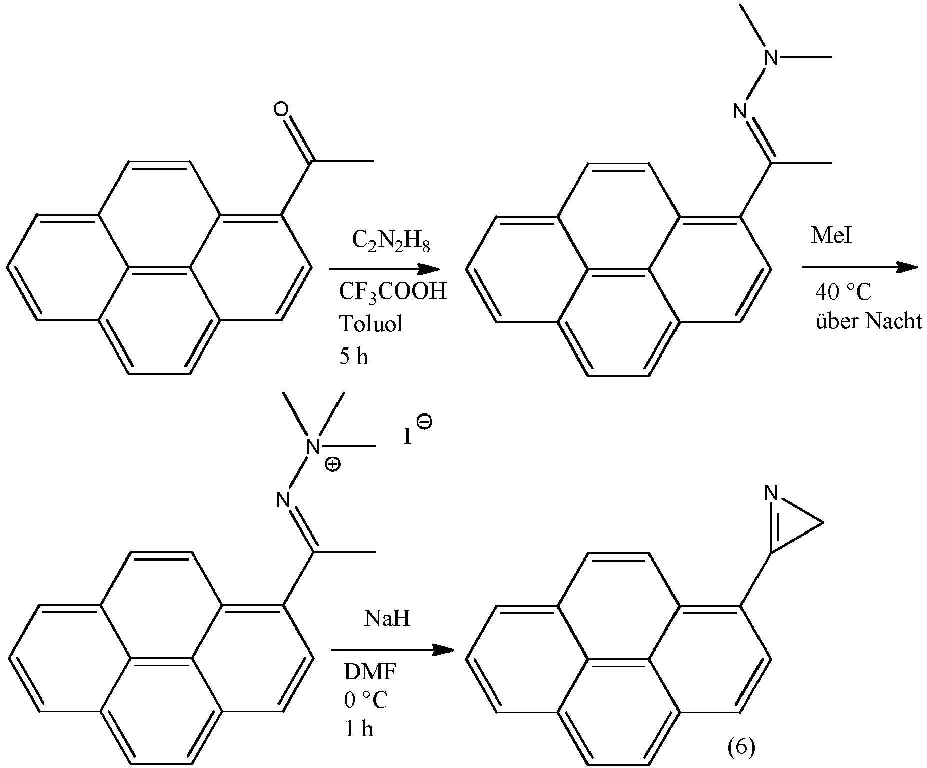

Bei der Komponente B1 kann es sich beispielsweise um ein Polyolefin, insbesondere um Polybutadien, einen Polyester, ein Polyurethan, ein Polyamid, einen Polyether oder ein Poly(meth)acrylat handeln. Andere Beispiele für Polyolefine sind EPDM, SBR, SBS, ABS, Chloropren-Kautschuke, Poly-α-Olefine und Polyisoprene.

Die Schreibweise Poly(meth)acrylat umfasst in diesem Zusammenhang sowohl Polyacrylate als auch Polymethacrylate, sowie Mischpolymere aus Acrylaten und Methacrylaten. Ferner können diese Poly(meth)acrylate zusätzlich mit Acrylaten bzw. Methacrylaten copolymerisierbare Monomere wie zum Beispiel Styrol oder Itaconsäure enthalten. Beispiele für geeignete Poly(meth)acrylate sind insbesondere solche, die Vinyl- oder Allylgruppen aufweisen.

Als besonders geeignete Gruppe mit einer C-C-Doppelbindung haben sich erfindungsgemäß insbesondere Methacryl-, Acryl-, Alkylfumarat- und Alkylmaleinat-Gruppen erwiesen. Solche Gruppen lassen sich sehr einfach durch Veresterung mit Hydroxyfunktionen an Polyestern, Polyethern, Polyurethanen oder Polyamiden realisieren. Aufgrund der α-Stellung der C-C-Doppelbindung zu einer Carbonylgruppe sind solche Gruppen aktiviert und damit besonders reaktiv.

Eine solche Aktivierung erfolgt alternativ zu den genannten Gruppen durch Konjugation der C-C-Doppelbindung zu einer Carbonyl-, Thiooxy-, Sulfo-, Sulfino-, Nitro-, Nitroso-, Azo-, Cyano-, Isocyanato-, Imin-Gruppe oder zu einer anderen C-C-Doppelbindung.

Besonders geeignete Beispiele für die Komponente B2 sind Maleinsäurediester, Fumarsäurediester, Bismaleimid oder multifunktionelle (Meth)acrylate, wie z.B. Glycol-dimethacrylat.

In einer ersten Variante enthält die Zusammensetzung die Komponente B1 und eine Komponente A, die genau eine Azirin-Gruppe aufweist. Bei dieser Variante wird die Komponente B durch Bestrahlung mit sichtbarem Licht mit der Komponente A verknüpft. So ist es möglich, Polymere, die mindestens eine, durchaus aber auch relativ viele Doppelbindungen aufweisen, mit der Komponente A zu funktionalisieren. Dazu kann die Komponente A beispielsweise neben der Azirin-Gruppe eine weitere Funktionalität aufweisen. Von einer Funktionalität kann aber auch gesprochen werden, wenn keine solche zweite Funktionalität vorliegt. In einem solchen Fall wird das Polymer ausschließlich mit einem polycyclischen Aromaten funktionalisiert. Polymere, solche Gruppen aufweisend sind insbesondere als Dispergieradditive, z.B. für Rußpigmente, geeignet. Auch können solche Polymere zur Oberflächenmodifizierung von Graphit oder Graphen eingesetzt werden.

In einer zweiten Variante weist die Zusammensetzung Komponenten A und B1 auf. Dabei hat die Komponente A genau zwei Azirin-Gruppen und die Komponente B hat genau eine oder zwei C-C-Doppelbindungen. Mit dieser Variante ist es möglich, eine Polyaddition durchzuführen, mittels derer das Molekulargewicht der Zusammensetzung durch Bestrahlung mit sichtbarem Licht erhöht werden kann. Dabei kann das erzielte Molekulargewicht mittels des Verhältnisses der Komponenten zueinander, dem Funktionalisierungsgrad eins oder zwei der Komponente B1, bzw. wenn beide Funktionalisierungsgrade vorliegen mittels deren Verhältnis zueinander und - bedingt - durch die Bestrahlungsdauer eingestellt werden. Für den Fall, dass es sich bei Komponente A gleichfalls um ein Polymer, z.B. einen Polyether oder ein Polyester, handelt, können auf diese Weise Polymere mit Blockstrukturen realisiert werden.

In einer dritten Variante enthält die Zusammensetzung Komponenten A und B1, wobei die Komponente A mindestens zwei Azirin-Gruppe, die Komponente B1 mindestens zwei C-C-Doppelbindungen und mindestens eine der Komponenten A oder B1 mindestens drei der jeweiligen Funktionalität aufweist. Eine solche Zusammensetzung ist durch Bestrahlung mit sichtbarem Licht vernetzbar.

Eine vierte Variante schließlich enthält die Komponenten A und B2, wobei die Komponente A bevorzugt mindestens zwei Azirin-Gruppen C-C-Gruppen aufweist. Für den Fall, dass die Komponente A eine Azirin-Gruppe hat, handelt es sich hierbei um eine Doppelfunktionalisierung einer Komponente B2. Für den Fall, dass beide Komponenten jeweils zwei Funktionalitäten haben, ist diese Variante als Modifikation der zweiten Variante anzusehen. Dies ist dann eine neuartige Polymerisationsmethode. Für den Fall, dass eine der Komponenten A oder B2 zwei oder mehr Funktionalitäten und die jeweils andere mindestens drei Funktionalitäten aufweist, handelt es sich bei dieser Methode um eine Vernetzungsmethode einer niedermolekularen Zusammensetzung und damit um eine Modifikation der dritten Variante.

Zusammensetzungen, enthaltend Komponente B2, insbesondere wenn mittels dieser Polymere oder vernetzte Produkte gebildet werden unterliegen hier der gleichen erfinderischen Idee wie die Zusammensetzungen, die von Polymeren in Form der Komponenten B1 ausgehen. In allen Fällen werden auf eine bis dato unbekannte Methode neuartige Polymere bzw. Elastomere oder Duroplasten gebildet, wobei mit der Variante, enthaltend die Komponente B2 die Bildung von Elastomeren ausgeschlossen werden kann.

Das genaue Verhältnis der Azirin-Gruppen zu den C-C-Doppelbindungen ist in allen Varianten relativ frei wählbar. In Variante 1 kann damit der Funktionalisierungsgrad eingestellt werden. In Variante 2 kann dadurch die Kettenlänge und in Variante drei der Vernetzungsgrad beeinflusst werden.

In weiteren Ausführungsformen der Erfindung weisen die Komponenten A und/oder B - unabhängig von der ansonsten verwendeten Variante der Erfindung - weitere funktionelle Gruppen auf. Insbesondere kann mittels dieser die Zusammensetzung über einen zweiten Mechanismus zusätzlich ausgehärtet werden. Wenn eine solche Ausführungsform verwendet wird, handelt es sich bei diesem Aushärtemechanismus besonders bevorzugt um eine reversible Hetero-Diels-Alder-Reaktion. Die Bedingungen und Synthese der Komponenten für eine solche Reaktion können beispielsweise in EP 2 536 797, EP 2 536 796 oder in EP 2 614 119 nachgelesen werden. Vorteil der Kombination mit einem zweiten Vernetzungsmechanismus ist es beispielsweise, dass man mit dem ersten Mechanismus eine Anvernetzung oder eine Molekulargewichtserhöhung bewirken kann, nach der eine Formgebung noch möglich ist. Mit dem zweiten Mechanismus erfolgt danach eine Fixierung des Bauteils. Dabei ist es möglich den erfindungsgemäßen Mechanismus als erste oder als zweite Stufe einzusetzen. Die Kombination mit einem reversiblen Mechanismus ermöglicht darüber hinaus noch mehr Freiheitsgrade bei der Verarbeitung von Werkstücken.

Ein weiteres Beispiel für einen zweiten Reaktionsmechanismus ist die Kombination aus Uretdionen und OH-Gruppen, die zu Urethangruppen reagieren können.

Die erfindungsgemäßen Formulierungen können vielfältig angewendet werden. So können die Zusammensetzungen der ersten Variante insbesondere zur Funktionalisierung eines Polymers, zur Synthese eines Dispergieradditivs oder zur Oberflächenmodifikation eines Graphens oder Graphits eingesetzt werden.

Die Zusammensetzungen der zweiten Variante, sowie der vierten Variante in der Form der Bildung eines thermoplastischen Polymers können vor allem zur Kupplung von Polymerketten, insbesondere in Kleb-, Dichtstoff-, Fugen-, Lack-, Composite-, Beschichtungsformulierungen, in Formulierungen für den 3D-Druck, zur Herstellung von Formteilen oder in Formulierungen für Medizin- Dental oder Orthopädieanwendungen Verwendung finden.

Die Zusammensetzungen der dritten Variante, sowie der vierten Variante in der Form der Bildung eines elastomeren oder duroplastischen Polymers können bevorzugt zur Vernetzung einer Zusammensetzung, insbesondere in Kleb-, Dichtstoff-, Fugen-, Lack-, Composite-, Beschichtungsformulierungen, zur Herstellung von Formteilen, in Formulierungen für den 3D-Druck oder in Formulierungen für Medizin- Dental oder Orthopädieanwendungen eingesetzt werden.

Die Ausführungsform, in der die erfindungsgemäße Zusammensetzung mit einem anderen Vernetzungsmechanismus kombiniert ist, kann insbesondere zur endgültigen Aushärtung einer zuvor reversibel vernetzten Formulierung in einem Klebstoff, Dichtstoff, einem 3D-gedruckten Formteil oder einem Composite-Bauteil verwendet werden.

Bei den aufgeführten Composites kann es sich insbesondere um lang- oder endlosfaserverstärkte Materialien handeln.

### Beispiele

### Beispiel 1: Synthese eines einfach Arizin-funktionalisierten Pyrens (6)

2,00 g 1-Acetyl-pyren 8,29 mmol, 1,00 eq) wurden in 15 mL Toluol gelöst und anschließend mit 0,98 g N,N-Dimethylhydrazin (24,90 mmol, 3,00 eq) und einer katalytischen Menge Trifluoressigsäure (0,01 mL) versetzt. Diese Mischung wurde 5 h unter Rückfluss erhitzt und daraufhin auf Raumtemperatur abgekühlt. Die Lösung wurde mit weiteren 35 mL Toluol verdünnt und dreimal mit jeweils 50 mL Wasser ausgeschüttelt, bevor die organische Fraktion über Na₂SO₄ getrocknet wurde. Das Lösungsmittel wurde im Vakuum abgezogen. Das verbleibende, gelbe Rohprodukt wurde ohne jede weitere Aufarbeitung in der nächsten Stufe eingesetzt und dazu in 10 mL Methyljodid aufgenommen und über Nacht bei 40 °C gerührt. Die verbleibende Suspension wurde mit 100 mL Diethylether versetzt, ein entstandener Niederschlag abfiltriert und dieser Feststoff mit weiteren 100 mL gewaschen. Der gewaschene Feststoff wurde daraufhin in 100 mL Dichlormethan gelöst und durch das Zutropfen von 100 mL Diethylether gefällt. Nach Filtration wurden 1,5 g Hydrazoniumsalz in Form eines gelben Pulvers erhalten. Dies entspricht einer Ausbeute der zweiten Stufe von 55 %.

0,70 g Hydrazoniumsalz der Vorstufe (1,63 mmol, 1,00 eq) wurden in 10 mL getrocknetem DMF gelöst und auf 0 °C in einem Eisbad abgekühlt. Dazu wurden 0,26 g einer 60 gew%igen Natriumhydrid-Lösung (6,50 mmol, 3,99 eq) portionsweise zugegeben und die Mischung darauf weiterhin bei 0 °C für 1 h gerührt. 200 mL Diethylether wurden zu der Reaktionslösung gegeben und unlösliche Anteile abfiltriert. Das Filtrat wurde darauf fünfmal mit jeweils 100 mL Wasser gewaschen, über Na₂SO₄ getrocknet und zuletzt volatile Bestandteile, wie das Lösungsmittel, im Vakuum entfernt. Dieses Rohprodukt wurde des weiteren säulenchromatographisch gereinigt (Eluent: Hexan/Ethylacetat mit einem Gradienten von 9 zu 1 auf 5 zu 1). Das Produkt wurde in Form eines gelben Pulvers in einer Ausbeute von 80 mg (entspricht 20 %) erhalten. Eine Charakterisierung und ein Nachweis der Reinheit von über 99% wurden mittels ¹H-NMR nachgewiesen.

### Beispiel 2: Beispielreaktion unter Bestrahlung mit sichtbarem Licht:

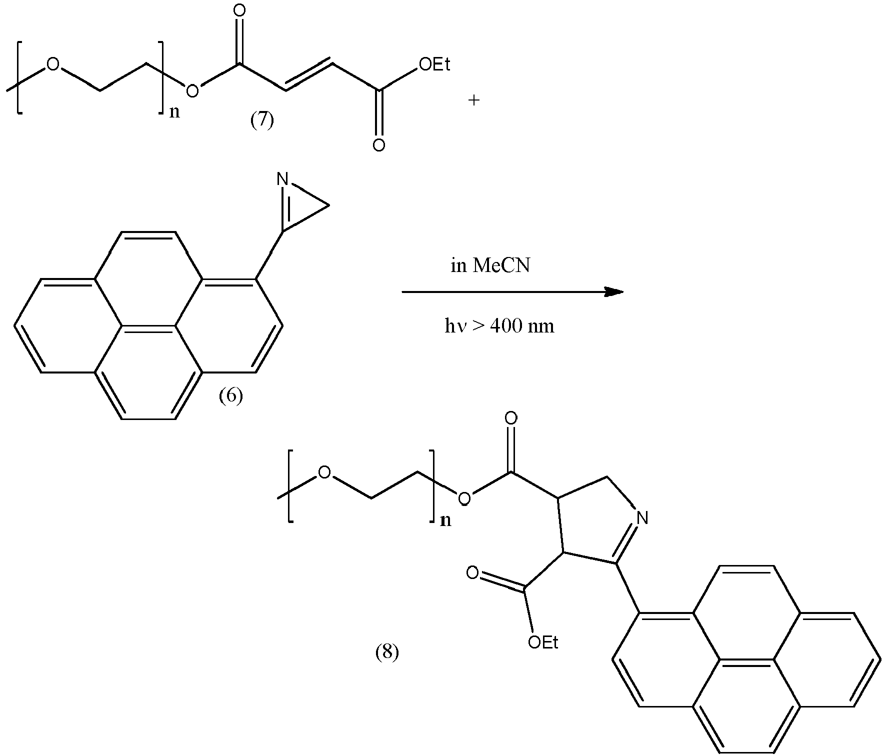

1,0 mg eines Fumarat-endgruppenfunktionalisiertes Polyethylenglycols (7) mit einem zahlenmittleren Molekulargewicht Mₙ von 2200 g/mol (0,45 µmol, 1,0 eq) wurden zusammen mit 1,0 mg des Produktes aus Beispiel 1 (6) (2,3 µmol, 5,0 eq) in ein Headspace-Vial (Pyrex, Durchmesser 20 mm) gegeben. Das Vial wurde darauf mit einem Crimp, der ein PTFE-Septum aufwies, verschlossen. Der Feststoff wurde darauf in 5 mL Acetonitril gelöst und das Vial in einen Photoreaktor gestellt. Nach einer Stunde wurde eine 0,1 mL Probe entnommen und erst darauf die Lampe eingeschaltet. Nach weiteren 1, 2, 3 und 4 Minuten wurden weitere Proben entnommen und im Weiteren dunkel gelagert und vermessen. Die Proben wurden jeweils mittels eines ESI-MS analysiert. Dabei konnte bestimmt werden, dass bereits nach 1 min - auf Basis des bestimmten Molekulargewichts - über 60 % der Komponente (7) und bereits nach 2 min Bestrahlung die Gesamte Komponente (7) zu dem Produkt (8) umgesetzt wurde.

Diese Ergebnisse sind über die Anzahl der jeweiligen Funktionalitäten einfach auf vernetzende, funktionalisierende oder molekulargewichtsaufbauende Zusammensetzungen zu übertragen.

## Patentansprüche

1. Zusammensetzung, **dadurch gekennzeichnet, dass** die Zusammensetzung als Komponente A ein Verbindung, aufweisend mindestens einen polycyclischen Aromaten, wiederum aufweisend mindestens eine Azirin-Gruppe, und als Komponente B ein Verbindung, aufweisend mindestens eine C-C-Doppelbindung, enthält, dass es sich bei der Verbindung A und/oder B um ein Polymer handelt, und dass in der Zusammensetzung mit sichtbarem Licht bei Raumtemperatur die Komponente A mit der Komponente B zu einer Reaktion der Azirin-Gruppen mit den C-C-Doppelbindungen gebracht werden kann.

2. Zusammensetzung gemäß Anspruch 1, **dadurch gekennzeichnet, dass** Komponente A genau eine Azirin-Gruppe aufweist, und dass die Komponente B durch Bestrahlung mit sichtbarem Licht mit der Komponente A verknüpfbar ist.

3. Zusammensetzung gemäß Anspruch 1, **dadurch gekennzeichnet, dass** Komponente A genau zwei Azirin-Gruppen aufweist, dass die Komponente B genau eine oder zwei C-C-Doppelbindungen aufweist, und dass das Molekulargewicht der Zusammensetzung durch Bestrahlung mit sichtbarem Licht erhöht werden kann.

4. Zusammensetzung gemäß Anspruch 1, **dadurch gekennzeichnet, dass** Komponente A mindestens zwei Azirin-Gruppe und die Komponente B mindestens zwei C-C-Doppelbindungen aufweist, wobei mindestens eine der Komponenten A oder B mindestens drei der jeweiligen Funktionalität aufweist, und dass die Zusammensetzung durch Bestrahlung mit sichtbarem Licht vernetzbar ist.

5. Zusammensetzung gemäß mindestens einem der Ansprüche 1 bis 4, **dadurch gekennzeichnet, dass** es sich bei dem Polymer um ein Polyolefin, insbesondere um Polybutadien, einen Polyester, ein Polyurethan, ein Polyamid, einen Polyether oder ein Poly(meth)acrylat handelt.

6. Zusammensetzung gemäß mindestens einem der Ansprüche 1 bis 5, **dadurch gekennzeichnet, dass** es sich nur bei der Verbindung B um ein Polymer handelt.

7. Zusammensetzung gemäß mindestens einem der Ansprüche 1 bis 6, **dadurch gekennzeichnet**, die C-C-Doppelbindungen in Komponente B konjugiert zu einer Carbonyl-, Thiooxy-, Sulfo-, Sulfino-, Nitro-, Nitroso-, Azo-, Cyano-, Isocyanato-, Imin-Gruppe oder zu einer C-C-Doppelbindung sind.

8. Zusammensetzung gemäß mindestens einem der Ansprüche 1 bis 7, **dadurch gekennzeichnet, dass** es sich bei dem polycyclischen Aromaten in Komponente A um einen mit mindestens einer Azirin-Gruppe funktionalisiertes Pyren, Anthracen, Phenalen, Phenanthren, Tetracen, Chrysen, Perylen, Pentacen, Pentaphen oder Coronen handelt.

9. Zusammensetzung gemäß Anspruch 8, **dadurch gekennzeichnet, dass** Komponente A ausschließlich aus dem polycyclischen Aromaten, einer oder mehreren Azirin-Gruppen und optional bis zu vier anderen reaktive Gruppen besteht.

10. Zusammensetzung gemäß Anspruch 8, **dadurch gekennzeichnet, dass** es sich bei Komponente A um eine Verbindung handelt, die mindestens zwei mit Azirin-Gruppen funktionalisierte polycyclische Aromaten aufweist, wobei entweder Kohlenstoffatome der Azirin-Gruppen oder Kohlenstoffatome in den polycyclischen Aromaten über einen Spacer miteinander verbunden sind.

11. Zusammensetzung gemäß mindestens einem der Ansprüche 1 bis 10, **dadurch gekennzeichnet, dass** Komponente A neben den Azirin-Gruppen eine zweite reaktive Gruppe aufweist.

12. Zusammensetzung gemäß mindestens einem der Ansprüche 1 bis 11, **dadurch gekennzeichnet, dass** die Zusammensetzung weitere funktionelle Gruppen aufweist, mittels derer die Zusammensetzung mittels eines zweiten Mechanismus aushärtbar ist.

13. Zusammensetzung gemäß Anspruch 12, **dadurch gekennzeichnet, dass** es sich bei dem zweiten Mechanismus um eine reversible Hetero-Diels-Alder-Reaktion handelt.

14. Verwendung einer Zusammensetzung gemäß Anspruch 2 zur Funktionalisierung eines Polymers, zur Synthese eines Dispergieradditivs oder zur Oberflächenmodifikation eines Graphens.

15. Verwendung einer Zusammensetzung gemäß Anspruch 3 zur Kupplung von Polymerketten, insbesondere in Kleb-, Dichtstoff-, Fugen-, Lack-, Composite-, Beschichtungsformulierungen, zur Herstellung von Formteilen, in Formulierungen für den 3D-Druck oder in Formulierungen für Medizin- Dental oder Orthopädieanwendungen.

16. Verwendung einer Zusammensetzung gemäß Anspruch 4 zur Vernetzung einer Zusammensetzung, insbesondere in Kleb-, Dichtstoff-, Fugen-, Lack-, Composite-, Beschichtungsformulierungen, zur Herstellung von Formteilen, in Formulierungen für den 3D-Druck oder in Formulierungen für Medizin- Dental oder Orthopädieanwendungen.

17. Verwendung einer Zusammensetzung gemäß Anspruch 13 zur endgültigen Aushärtung einer zuvor reversibel vernetzten Formulierung in einem Klebstoff, Dichtstoff, einem 3D-gedruckten Formteil oder einem Composite-Bauteil.
